# EUROPÄISCHE PATENTANMELDUNG

(11) **EP 0 578 856 A1**
(43) Veröffentlichungstag der Anmeldung: **19.01.1994**
(21) Anmeldenummer: 92112152.1
(22) Anmeldetag: 16.07.1992
(51) Int. Cl.: H01L 21/334, H01G 9/02

(54) **Mikro-Kondensator**

(71) Anmelder: International Business Machines Corporation, Armonk, N.Y. 10504 (US)
(72) Erfinder: Beuttler, Gerhard, W-7032 Sindelfingen 6 (DE); Boehmer, Gudrun, Dipl.-Ing., W-7000 Stuttgart 80 (DE); Elsner, Gerhard, Dipl.-Phys., W-7032 Sindelfingen (DE); Hinkel, Holger, Dipl.-Phys., W-7268 Gechingen (DE); Kempf, Jürgen, W-7268 Gechingen (DE)
(74) Vertreter: Schäfer, Wolfgang, Dipl.-Ing.

(57) **Zusammenfassung**

Vorgestellt wird ein neuartiger Kondensator der hohe Kapazität bei gleichzeitig geringem Volumen aufweist. Dazu wird in einem Substrat (2, 6) aus elektrisch leitfähigem Material (Metall, dotierter Halbleiter) eine poröse Struktur (1) geformt und anschließend die innere Oberfläche (8) dieser Struktur mit einem nichtleitendem Material beschichtet. Danach wird auf die gebildete Schicht (9) aus nichtleitendem Material eine weitere Schicht (10) aus leitfähigen Material aufgebracht. Auf diese Weise wird im Substrat eine poröse, schwammartige Struktur mit einer extrem großen inneren Oberfläche erzeugt, die zusammen mit der dielektrischen Trennschicht (9) und deren leitender Beschichtung einen Kondensator bildet. Da die Kapazität wesentlich durch die Größe der Kondensatorfläche bestimmt wird, ist sie entsprechend groß bei gleichzeitig geringem Volumenbedarf. Die Erfindung umfaßt das Verfahren zur Herstellung solcher Kondensatoren und Anwendungsbeispiele.

## Beschreibung

Die Erfindung liegt auf dem Gebiet der Elektronik und betrifft insbesondere Komponenten integrierter Schaltungen. Vorgestellt wird ein neuartiger Kondensator der hohe Kapazität bei gleichzeitig geringem Volumen aufweist. Die Erfindung umfaßt das Verfahren zur Herstellung solcher Kondensatoren und Anwendungsbeispiele.

Im Zuge ständiger Miniaturisierung elektronischer Bauteile ist man auch bemüht Kondensatoren zu verkleinern. Eine einfache Reduzierung der Dimensionen führt jedoch auf grundsätzliche Schwierigkeiten, da die elektrischen Eigenschaften direkt von den Abmessungen abhängen. Die Kapazität eines Kondensators ist (neben anderen Faktoren) wesentlich bestimmt durch das Flächenmaß zweier einander im geringen Abstand gegenüberstehenden Flächen aus elektrisch leitenden Material. Um Kondensatoren mit hoher Kapazität und kleinem Volumen als diskrete Bauteile herzustellen, werden üblicherweise die durch ein Dielektrikum elektrisch getrennten Flächen mehrfach gefaltet oder aufgerollt. Solche Techniken sind jedoch für miniaturisierte Ausführungen, insbesondere für integrierte Schaltungen, nicht oder nur sehr eingeschränkt übertragbar.

Ausgehend von diesem bekannten Stand der Technik liegt der vorliegenden Erfindung die Aufgabe zugrunde, einen verbesserten Mikrokondensator mit hoher Kapazität bei kleinem Volumen sowie ein Verfahren zu seiner Herstellung zu entwickeln, welches auch für integrierte Schaltungen geeignet ist.

Erfindungsgemäß wird diese Aufgabe gemäß den Ansprüchen dadurch gelöst, daß in einem Substrat aus elektrisch leitfähigem Material (Metall, dotierter Halbleiter) eine poröse Struktur geformt wird, anschließend die innere Oberfläche dieser Struktur mit einem nichtleitendem Material beschichtet und danach auf die gebildete Schicht aus nichtleitendem Material eine weitere Schicht aus leitfähigen Material aufgebracht wird. Diese Schicht ist also von dem leitfähigen Substrat elektrisch getrennt. Auf diese Weise wird im Substrat eine poröse, schwammartige Struktur mit einer extrem großen inneren Oberfläche erzeugt, die zusammen mit der dielektrischen Trennschicht und deren leitender Beschichtung einen Kondensator bildet. Da die Kapazität wesentlich durch die Größe der Kondensatorfläche bestimmt wird, ist sie entsprechend groß bei gleichzeitig geringem Volumenbedarf.

Weitere Einzelheiten und Vorteile der Erfindung und des bevorzugten Herstellungsverfahrens werden anhand der folgenden Ausführungsbeispiele unter Bezugnahme auf die Zeichnungen erläutert.

Es zeigen im einzelnen :
- Fig. 1: die Erstellung einer porösen Struktur in einem leitfähigen Substrat;
- Fig. 2: wie Fig. 1, wobei das Substrat nur in einem begrenzten Volumenbereich elektrisch leitfähig ist;
- Fig. 3: einen vergrößerten Ausschnitt der porösen Struktur;
- Fig. 4: die nachfolgende Bildung einer dielektrischen Schicht auf der inneren Oberfläche der porösen Struktur (vergrößerter Ausschnitt);
- Fig. 5: als nächsten Herstellungsschritt die Bedeckung der dielektrischen Schicht mit einem leitfähigen Material (vergrößerter Ausschnitt);
- Fig. 6: den elektrischen Anschluß an das leitfähige Material;
- Fig. 7: ein Ausführungsbeispiel des erfindungsgemäßen Kondensator als diskretes Bauelement;
- Fig. 8: ein alternatives Ausführungsbeispiel;
- Fig. 9: elektrische Parallel- oder Serienschaltung mehrerer Kondensatoren auf einem Substrat;
- Fig. 10: die Implementierung des erfindungsgemäßen Kondensators in einer DRAM Speicherzelle.

Die Herstellung poröser Strukturen ist aus dem Stand der Technik bekannt (siehe z.B.: G. Bomchil, A. Halimaoui, "Porous silicon: The material and its applications to SOI technologies", Microelectronic Engineering 8, 1988, pp. 293-210).

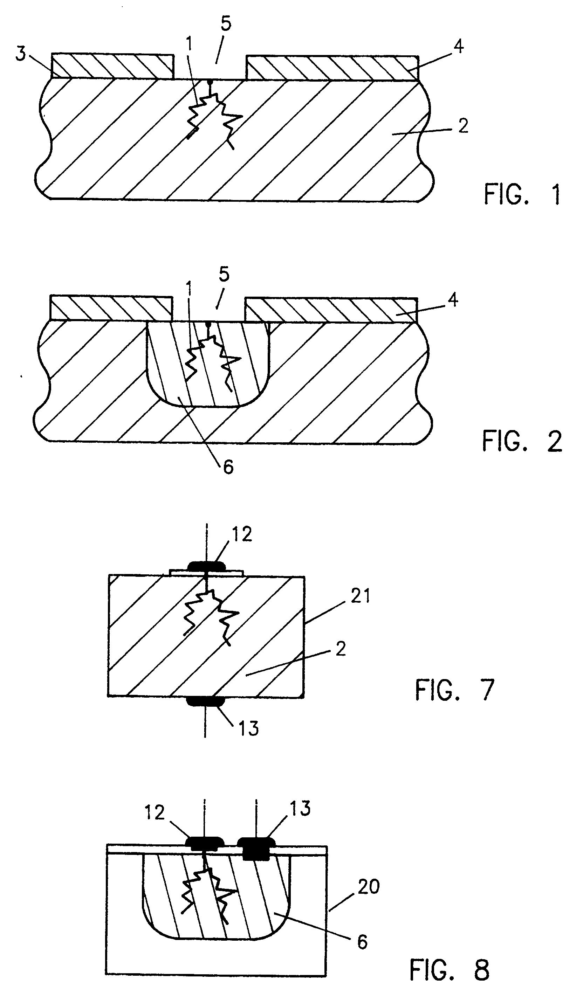

Bei dem bevorzugten Ausführungsbeispiel wird, wie in Fig. 1 dargestellt, zunächst nach den bekannten Verfahren eine poröse Struktur 1 in ein leitfähiges Substrat 2 geätzt. Zur Beschränkung des Ätzvorgangs auf lokale Bereiche des Substrats kann dabei die Substratoberfläche 3 mit einer resistenten Schutzschicht 4 bedeckt sein, die nur an den gewünschten Stellen Öffnungen 5 aufweist, so daß dort das Substrat freiliegt.

Das Substrat muß nicht homogen elektrisch leitfähig sein. Es ist ausreichend, wenn - wie in Fig. 2 dargestellt - der Volumenbereich 6 leitfähig ist, in dem der erfindungsgemäße Kondensator erzeugt werden soll.

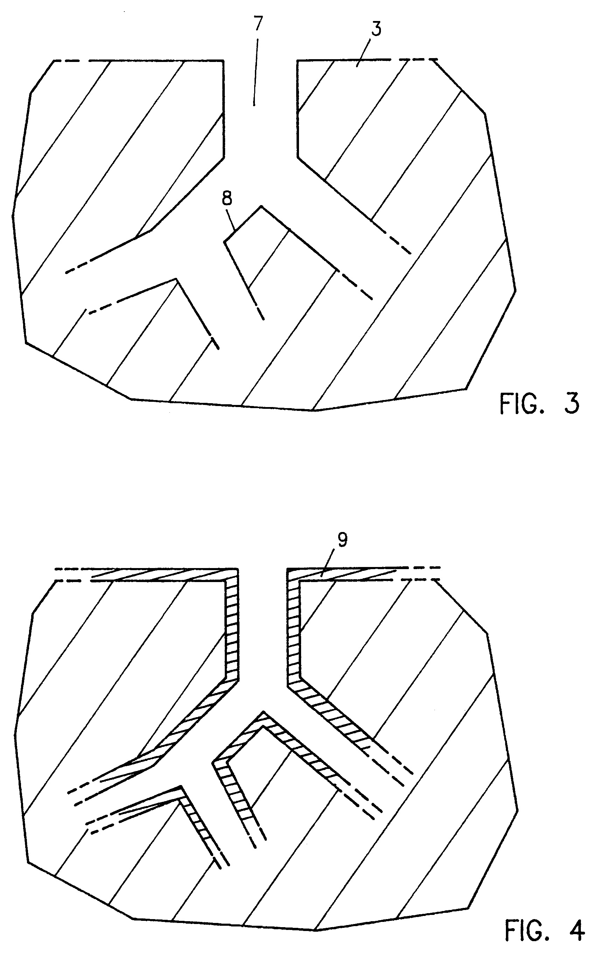

Als Ausgangssubstrat eignet sich z.B. p-dotiertes Silizium mit einer Leitfähigkeit von 1.0 bis 0.01 Ohm·cm (Silizium als Substratmaterial ist speziell bei integrierten Schaltungen üblich). Zur Ausbildung der porösen Struktur wird das Silizium lokal elektrochemisch aufgelöst. Hierbei lassen sich Bedingungen auswählen, die im Substrat baumartig verästelte, zylindrische Poren 7 mit einem mittleren Durchmesser von etwa 10 nm erzeugen. Ein vergrößerter Ausschnitt der porösen Struktur ist in Fig. 3 wiedergegeben.

Bei den bekannten Ätzverfahren werden Stromdichten von 10 - 100 mA/cm² eingesetzt und Flußsäure in einer Konzentration von 20% - 50% als Ätzmedium verwendet. Die erzielte Porosität (Porenvolumen / Substratvolumen) liegt üblicherweise zwischen 20% und 75% .

In einem weiteren Schritt (Fig. 4) wird eine dielektrische Trennschicht 9 auf der inneren Oberfläche 8 der porösen Struktur erzeugt. Dazu wird die Siliziumoberfläche 8 vorzugsweise oxidiert. Die Oxidation kann dabei in zwei Schritten erfolgen: zunächst wird durch Einwirkung von trockenem Sauerstoff bei einer Temperatur von ca. 300°C eine Monolage Oxid gebildet, anschließend wird diese dünne Oxidschicht durch Tempern bei höheren Temperaturen (800 - 1000°C) bis zur gewünschten Dicke (z.B. 5 nm) verstärkt. Auch Siliziumnitrid kann als Dielektrikum verwendet werden.

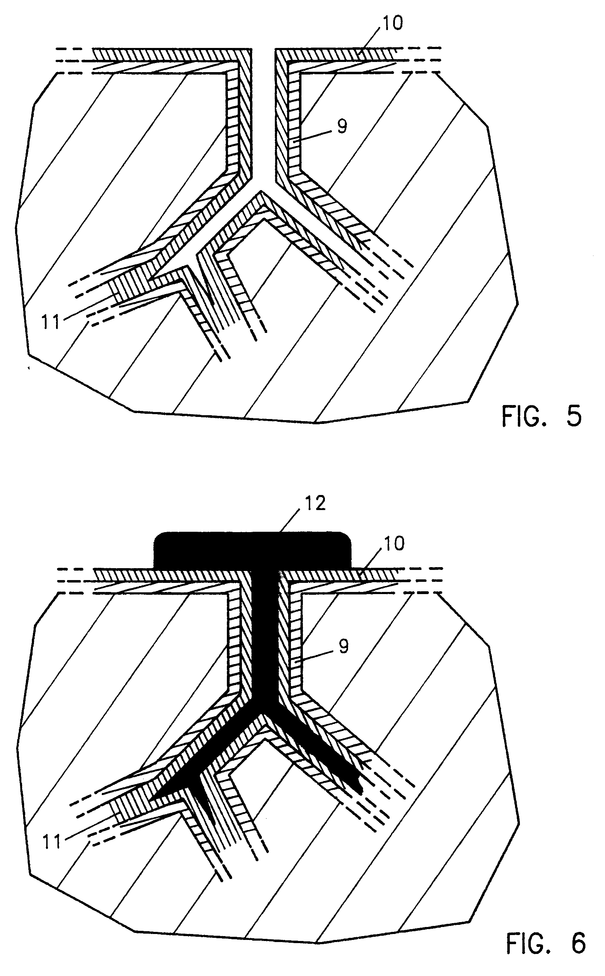

Auf die dielektrische Trennschicht 9 wird anschließend eine elektrisch leitende Schicht 10 aufgebracht, die als zweite Fläche des Kondensatorflächenpaares dient (Fig. 5). Diese Schicht kann beispielsweise aus dotiertem Silizium bestehen, das mittels bekannter CVD Techniken auf dem Dielektrikum abgeschieden wird. Auch Metalle können auf diese Weise aufgebracht werden. Alternativ kann die elektrisch leitende Schicht 10 auch direkt durch eine teilweise Reduktion des Dielektrikums 9 erzeugt werden.

In den feineren Verästelungen der porösen Struktur kann die leitfähige Schicht 10 auch zusammenwachsen. Somit können auch einzelne Poren 11 vollständig mit leitfähigem Material ausgefüllt werden. Dies hat jedoch keinen schädlichen Einfluß auf die Funktion des erfindungsgemäßen Kondensators.

Die Kontaktierung der elektrisch leitenden Schicht zur Zuführung elektrischer Ladung kann in einem weiteren Schritt durch entsprechende, in der Halbleitertechnologie bekannte Verfahren erfolgen. In Fig. 6 ist schematisch ein Anschluß 12 dargestellt. Dieser kann beispielsweise aus dotiertem Polysilizium bestehen, aber auch andere leitfähige Substanzen (Metalle, Legierungen) sind geeignet.

Ein Ausführungsbeispiel des erfindungsgemäßen Kondensators als diskretes Bauelement 20 ist in Fig. 7 dargestellt. Anschluß 12 entspricht der in Figur 6 dargestellten Form und ist nur mit der leitenden Schicht 10 (zweite Kondensatorplatte) des erfindungsgemäßen Kondensators verbunden. Die Isolation gegenüber dem Substrat erfolgt durch die dielektrische Schicht 9 (in Fig. 7 und 8 nur schematisch dargestellt). Anschluß 13 steht in direktem Kontakt mit dem leitenden Substrat 2. Zwischen den beiden Anschlüssen 12, 13 liegt die gesamte Kapazität des Kondensators.

Fig. 8 zeigt das entsprechende Ausführungsbeispiel für eine Anordnung nach Figur 2. Dabei ist das Substratmaterial nur in einem begrenzten Volumenbereich 6 elektrisch leitend (z.B. dotiert). Anschluß 13 steht hier nur in direktem Kontakt mit dem leitenden Volumenbereich 6.

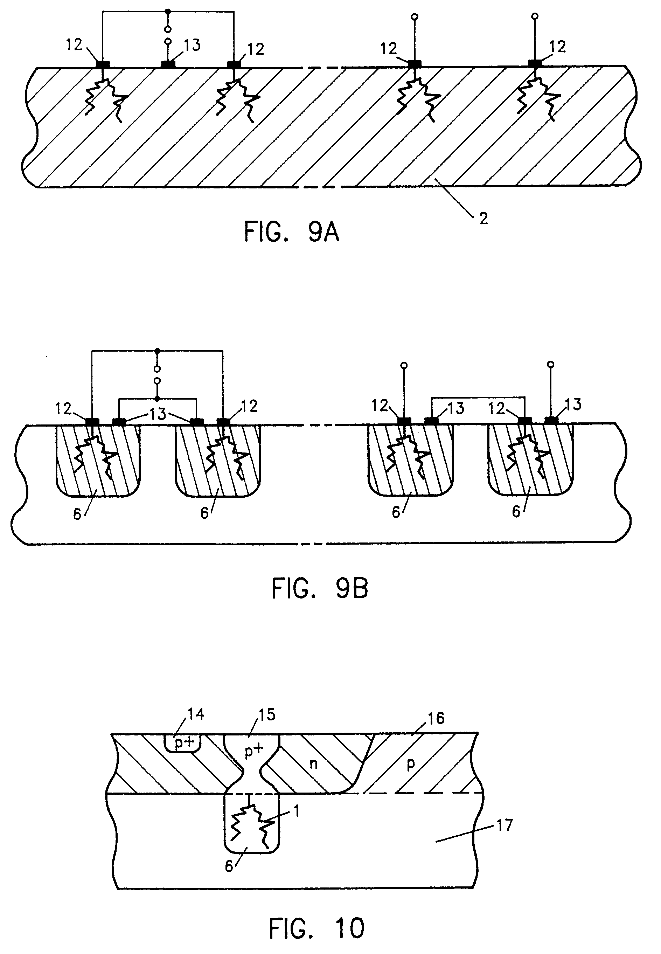

Mehrere Kondensatoren können parallel oder seriell verbunden werden. Dies bietet die Möglichkeit aus einer Anzahl identischer Kondensatoren unterschiedliche Kapazitäten zu erzeugen. Fign. 9a und 9b zeigen Parallel- und Serienschaltung zweier Kondensatoren nach den in Fign. 1 und 2 dargestellten Ausführungsformen.

Zum Schutz gegen äußere Einflüsse können die erfindungsgemäßen Kondensatoren bei einer Ausführung als diskrete Bauelemente durch bekannte Verfahren gekapselt werden (nicht dargestellt).

Bei einer Implementierung des erfindungsgemäßen Kondensators in integrierten Schaltkreisen kann die elektrische Verbindung zu anderen funktionellen Komponenten auch direkt, d.h. ohne separate Ausbildung eines Kontaktes erfolgen. Als ein entsprechendes Anwendungsbeispiel ist die Verwendung des erfindungsgemäßen Kondensators in einer dynamischen Speicherzelle (DRAM) in Fig. 10 dargestellt. Dabei ist ein Schalttransistor, bestehend aus Source 14 und Drain 15, in eine epitaktisch auf einem Substrat 17 aufgebrachte Schicht 16 eingebettet. In diesem Beispiel ist der Kondensator (d.h. die zweite Kondensatorfläche) direkt mit dem Drain-Bereich 15 des Schalttransistors verbunden. Eine solche Anordnung zeichnet sich gegenüber bisherigen Speicherzellen, bei denen die Kapazität z.B. durch Trenches gebildet wird, durch den extrem geringen Raumbedarf aus. Dadurch können auch höchstintegrierte Speichermodule realisiert werden.

## Patentansprüche

1. Verfahren zur Herstellung eines elektrischen Kondensators,
dadurch gekennzeichnet, daß
in einem ersten Schritt in einem elektrisch leitfähigen Substrat (2,6) eine poröse Struktur (1) erzeugt wird,
in einem weiteren Schritt auf der internen Oberfläche (8) der porösen Struktur eine dielektrische Schicht (9) aufgebracht wird, und
in einem Folgeschritt die dielektrische Schicht (9) mit einem leitfähigen Material (10) bedeckt wird.

2. Verfahren nach Anspruch 1, wobei die poröse Struktur (1) durch elektrochemisches Ätzen erzeugt wird.

3. Verfahren nach Anspruch 1 oder 2, wobei die dielektrische Schicht (9) durch Oxidieren oder/und Nitrieren des Substratmaterials erzeugt wird.

4. Verfahren nach Anspruch 1, 2 oder 3, wobei das leitfähige Material (10) durch einen CVD Prozess auf die dielektrische Schicht (9) aufgebracht wird.

5. Verfahren zur Herstellung von Kondensatoren, dadurch gekennzeichnet, daß mehrere nach einem der vorhergehenden Ansprüche erzeugte Kondensatoren so elektrisch verbunden werden, daß die resultierende Gesamtkapazität sich von der Kapazität eines einzelnen Kondensators unterscheidet.

6. Mikrokondensator, dadurch gekennzeichnet, daß er aus einem zumindest teilweise elektrisch leitfähigen Substrat (2, 6) besteht, welches eine poröse Struktur (1) aufweist, wobei die innere Oberfläche (8) der porösen Struktur mit einer dielektrischen Schicht (9) bedeckt ist auf die ein elektrisch leitfähiges Material (10) aufgebracht ist.

7. Mikrokondensator nach Anspruch 6, wobei das Substrat (2, 6) aus dotiertem Silizium besteht.

8. Verwendung des Mikrokondensators nach Anspruch 6 oder 7, dadurch gekennzeichnet, daß der Mikrokondensator in einer integrierten Schaltung eingesetzt wird.

9. Verwendung des Mikrokondensators nach Anspruch 6 oder 7, dadurch gekennzeichnet, daß der Mikrokondensator als Speicherelement in einer dynamischen Speicherzelle eingesetzt wird.

10. Integrierte Schaltung zur Verarbeitung oder Speicherung elektrischer Signale, dadurch gekennzeichnet, daß sie zumindest einen Mikrokondensator nach Anspruch 6 oder 7 aufweist.

11. Integrierte Schaltung nach Anspruch 10, dadurch gekennzeichnet, daß der Mikrokondensator als Speicherelement in einer dynamischen Speicherzelle eingesetzt ist und die integrierte Schaltung einen dynamischen Speicher (DRAM) darstellt.
